# EUROPÄISCHE PATENTSCHRIFT

(11) **EP 4 099 722 B1**
(45) Veröffentlichungstag und Bekanntmachung des Hinweises auf die Patenterteilung: **16.10.2024**
(21) Anmeldenummer: 22169051.4
(22) Anmeldetag: 20.04.2022
(51) Int. Cl.: H04R 25/00, G01R 31/382, H01M 10/44, H02J 7/00

(54) **VERFAHREN ZUR INITIALISIERUNG EINES LANGZEIT-LAGERUNGSMODUS FÜR EIN HÖRINSTRUMENT**
METHOD FOR INITIALIZING A LONG-TERM STORAGE MODE FOR A HEARING INSTRUMENT
PROCÉDÉ D'INITIALISATION D'UN MODE DE STOCKAGE À LONG TERME POUR UN INSTRUMENT AUDITIF

(30) Priorität: 02.06.2021 DE 102021205635
(43) Veröffentlichungstag der Anmeldung: 07.12.2022
(73) Patentinhaber: Sivantos Pte. Ltd., Singapore 539775 (SG)
(72) Erfinder: ONG, Chuan En Andrew, 680157 Singapore (SG); LER, Gee Heng, 10150 Georgetown, Penang (MY); SIEW, Chee Kong, 530371 Singapore (SG); YAP, Heng Goh, 539775 Singapore (SG); REN, Shuang, Simon, 640940 Singapore (SG)
(74) Vertreter: FDST Patentanwälte

(56) Entgegenhaltungen:
- CN-C- 1 268 027

## Beschreibung

Die Erfindung betrifft ein Verfahren zur Initialisierung eines Langzeit-Lagerungsmodus für ein Hörinstrument, welches eine wiederaufladbare Batteriezelle aufweist. Die Erfindung betrifft weiter ein Hörinstrument mit einer wiederaufladbaren Batteriezelle.

Ein Hörinstrument ist generell als Vorrichtung zu verstehen, welche dazu eingerichtet ist, ein Schallsignal zu erzeugen und einem Gehör eines Benutzers des Hörinstruments zuzuführen. Das Schallsignal kann dabei durch einen Lautsprecher, oder einen vergleichbaren akustischen Ausgangswandler erzeugt werden, welcher dazu geeignet ist, in einer umgebenden Luft aus einem elektrischen Ausgangssignal entsprechende Luftdruckschwingungen zu generieren, welche das Schallsignal bilden, also z.B. auch durch einen thermo-akustischen Wandler. Insbesondere kann ein Hörinstrument für seinen Betrieb eine wiederaufladbare, vorzugsweise integrierte Batteriezelle aufweisen. Hörinstrumente können dabei gegeben sein durch Kopfhörer, Headsets, sog. Earbuds oder Hearables, aber auch durch Hörgeräte.

Ein Hörgerät ist allgemein als ein Hörinstrument zu verstehen, welches dazu vorgesehen und eingerichtet ist, eine Hörschwäche des Benutzers zu korrigieren bzw. auszugleichen. Hierfür weist das Hörgerät wenigstens einen elektro-akustischen Eingangswandler, z.B. in Form eines Mikrofons, und eine Signalverarbeitungseinrichtung auf, wobei der Eingangswandler aus einem Umgebungsschall ein entsprechendes elektrisches Eingangssignal generiert, das in der Signalverarbeitungseinrichtung in Abhängigkeit von der auszugleichenden Hörschwäche des Benutzers zum elektrischen Ausgangssignal verarbeitet wird, und dabei insbesondere frequenzabhängig verstärkt und/oder komprimiert werden kann. Insbesondere können daher auch Earbuds, welche über die genannten Funktionen verfügen, als Hörgeräte aufgefasst werden.

Wird ein Hörinstrument über einen längeren Zeitraum nicht verwendet, sind für eine Haltbarkeit der Batteriezelle je nach deren Bauart unterschiedliche Voraussetzungen für eine langfristige Lagerung zu erfüllen. Bei einer langfristigen Lagerung ohne Benutzung des Hörinstruments kann einerseits ein zu hoher Ladestand der Batterie dazu führen, dass bei einer Wiederaufnahme des Betriebs nicht mehr die volle Ladekapazität für die Batteriezelle erreicht werden kann. Anderseits kann ein zu niedriger Ladestand vor einer Aufbewahrung zu einer Tiefenentladung führen, welcher die Batteriezelle dauerhaft beschädigen oder gar zerstören kann.

Um daher die Dauer vom Abschluss der Fertigung eines Hörinstruments bis hin zu seiner Auslieferung an einen Endkunden ohne die genannten Gefahren für die Batteriezelle überstehen zu können, werden meist werksseitig entsprechende Schutzvorkehrungen getroffen. Für den Fall, dass der Benutzer ein Hörinstrument nach der Inbetriebnahme und Verwendung über einen längeren Zeitraum wieder lagern will, stehen ihm derartige Schutzvorkehrungen jedoch infolge der werksseitigen Implementierung üblicherweise nicht zur Verfügung.

Die CN 1 268 027 C nennt für ein tragbares elektronisches Gerät ein Überprüfen eines Ladezustandes einer wiederaufladbaren, im besagten Gerät verbauten Batterie während eines Herstellungsprozesses, um den Ladezustand der Batterie bei der Auslieferung des Gerätes (also beim Verlassen der Produktionsstätten) kontrollieren zu können. Ist der Ladezustand im Vergleich zu einem für eine Lagerung vorteilhaften Ladezustand zu hoch oder zu niedrig, wird die Batterie während einer werksinternen Testroutine entladen oder geladen, um zu verhindern, dass die Batterie während der Lagerung (etwa bis zu einer endgültigen Auslieferung an einen Benutzer) Schaden nimmt.

Der Erfindung liegt daher die Aufgabe zugrunde, für ein Hörinstrument ein Verfahren anzugeben, mittels dessen auch nach einer Verwendung bzw. Inbetriebnahme eine Langzeit-Lagerung ermöglicht wird, welche für eine Batteriezelle des Hörinstruments möglichst schonend ist. Der Erfindung liegt weiter die Aufgabe zugrunde, ein entsprechendes Hörinstrument anzugeben, welches für eine möglichst batterie-schonende Langzeit-Lagerung eingerichtet ist.

Die erstgenannte Aufgabe wird erfindungsgemäß gelöst durch ein Verfahren zur Initialisierung eines Langzeit-Lagerungsmodus für ein Hörinstrument, welches eine vorzugsweise integrierte wiederaufladbare Batteriezelle aufweist, wobei für eine Langzeit-Lagerung des Hörinstruments ein oberer Grenzwert einer Kenngröße für einen Ladezustand der wiederaufladbaren Batteriezelle vorgegeben wird, wobei im Rahmen einer Aktivierungsroutine einer Langzeit-Lagerung ein tatsächlich vorhandener Istwert der Kenngröße für den Ladezustand der Batteriezelle gemessen wird, der gemessene Istwert der Kenngröße für den Ladezustand der Batteriezelle mit dem mit dem oberen Grenzwert der Kenngröße für den Ladezustand verglichen wird, und für den Fall, dass der gemessene Istwert der Kenngröße über dem oberen Grenzwert für die Kenngröße liegt, die Batteriezelle wenigstens soweit entladen wird, bis die Kenngröße für den Ladezustand den vorgegebenen oberen Grenzwert erreicht hat, und das Hörinstrument in einen Langzeit-Lagerungsmodus versetzt wird, wobei wiederholt eine Nutzung des Hörinstruments überprüft wird, und die Aktivierungsroutine der Langzeit-Lagerung automatisch initiiert wird, sobald für wenigstens eine erste Zeitdauer keine Nutzung des Hörgerätes erfolgt ist. Vorteilhafte Ausgestaltungen sind Gegenstand der Unteransprüche und der nachfolgenden Beschreibung.

Die zweitgenannte Aufgabe wird erfindungsgemäß gelöst durch ein Hörinstrument, umfassend eine wiederaufladbare Batteriezelle, eine Messeinrichtung zum Messen eines Istwertes einer Kenngröße für einen Ladezustand der Batteriezelle, eine Vergleichseinrichtung zum Vergleich des gemessenen Istwertes der Kenngröße mit einem für eine Langzeit-Lagerung des Hörinstruments vorgegebenen oberen Grenzwert der Kenngröße für den Ladezustand der Batteriezelle, und eine Entladeeinrichtung, welche im Rahmen einer Aktivierungsroutine einer Langzeit-Lagerung des Hörinstruments für den Fall, dass der gemessene Istwert für die Kenngröße des Ladezustands der Batteriezelle über dem oberen Grenzwert liegt, dazu eingerichtet ist, die Batteriezelle des Hörinstruments wenigstens so weit zu entladen, bis die Kenngröße für den Ladezustand den oberen Grenzwert erreicht hat, wobei das Hörinstrument dazu eingerichtet ist, im Rahmen der Aktivierungsroutine der Langzeit-Lagerung bei einem Erreichen des Ladezustands, welcher dem vorgegebenen oberen Grenzwert der Kenngröße entspricht, einen Langzeit-Lagerungsmodus einzunehmen, wobei das Hörinstrument dazu eingerichtet ist, wiederholt eine Nutzung zu überprüfen, und die Aktivierungsroutine der Langzeit-Lagerung automatisch zu initiieren, sobald für wenigstens eine erste Zeitdauer keine Nutzung erfolgt ist.

Das erfindungsgemäße Hörinstrument teilt die Vorzüge des erfindungsgemäßen Verfahrens. Die für das Verfahren und für seine Weiterbildungen angegebenen Vorteile können sinngemäß auf das Hörinstrument übertragen werden.

Die Entladeeinrichtung des erfindungsgemäßen Hörinstruments kann insbesondere durch eine Prozessoreinheit gegeben sein, auf welcher alle Funktionen der Signalverarbeitung des Hörinstruments implementiert sind, sodass die Entladung durch den Betrieb (ggf. ohne Erzeugung eins Ausgangssignals) der Prozessoreinheit bewerkstelligt werden kann.

Unter einer wiederaufladbaren Batteriezelle ist insbesondere jedweder Energiespeicher umfasst, welcher dazu vorgesehen und eingerichtet ist, dass Hörinstrument einerseits im laufenden Betrieb und/oder in einem Stand-by-Modus mit Energie zu versorgen, und andererseits für besagte Energieversorgung wiederholt aufgeladen werden kann, beispielsweise mittels eines entsprechenden Ladegerätes, welches insbesondere für eine Verwendung in Verbindung mit dem Hörinstrument abgestimmt sein kann, etwa durch entsprechende Anschlüsse zur Energieübertragung oder eine Einrichtung zur drahtlosen Energieübertragung. Bevorzugt ist die wiederaufladbare Batteriezelle in das Hörinstrument derart integriert, dass der Benutzer für einen Ladevorgang die Batteriezelle nicht aus dem Hörinstrument entnehmen muss; insbesondere ist ein Herausnehmen der Batteriezelle aus dem Hörinstrument nicht vorgesehen, und gegebenenfalls auch gar nicht möglich, ohne dabei Komponenten des Hörinstrumentes potenziell zu gefährden. Die Batteriezelle kann insbesondere für den Lade- und Entlade-Mechanismus auf Lithium-Ionen basieren.

Unter einer Langzeit-Lagerung des Hörinstruments ist hierbei insbesondere eine Lagerung oder auch Aufbewahrung des Hörinstrumentes umfasst, welche einen üblichen Zeitraum für ein Abnehmen des Höheinstruments über Nacht oder auch bis zum nächsten Gebrauch bei einer regelmäßigen sportlichen Aktivität bei weitem übersteigt, also sich insbesondere über einen bis mehrere Monate erstreckt. Eine Langzeit-Lagerung kann jedoch auch bereits bei einer Betriebspause von einigen Wochen (beispielsweise während eines Urlaubs des Benutzers) gegeben sein. Der Langzeit-Lagerungsmodus ist hierbei insbesondere als eine konkrete Konfiguration aufzufassen, welche für besagte Langzeit-Lagerung hinsichtlich der Haltbarkeit der Batteriezelle optimiert ist, und dabei sämtliche eine Energieverwaltung des Hörinstruments Betriebsparameter betrifft.

Als Kenngröße für einen Ladezustand der wiederaufladbaren Batteriezelle kann hierbei insbesondere eine an der Batteriezelle anliegende Spannung und/oder ein von der Batteriezelle abgegebener Strom gegeben sein. Insbesondere besteht zwischen der Kenngröße und dem Ladezustand ein monotoner Zusammenhang.

In diesem Sinne ist der vorgegebene obere Grenzwert für besagte Kenngröße für eine Langzeit-Lagerung des Hörinstruments insbesondere derart gegeben, dass der dem oberen Grenzwert entsprechende Ladezustand einerseits auch nach Monaten ohne ein Laden und ohne eine externe Leistungsentnahme aus der Batteriezelle eine möglichst hohe Ladekapazität für die Batteriezelle sicherstellt, und andererseits die Batteriezelle wirksam vor einer Tiefenentladung in diesem Zeitraum ohne Leistungsentnahme und Laden schützt. Der dem oberen Grenzwert entsprechende Ladezustand und/oder der zugehörige obere Grenzwert der Kenngröße kann hierbei insbesondere von einem Hersteller der Batteriezelle vorgegeben sein, und/oder anhand von Messungen ermittelt werden, bei welchen die Batteriezelle jeweils auf einen bestimmten Anteil der maximalen Ladekapazität aufgeladen wird, und nach einem normierten Aufbewahrungszeitraum ermittelt wird, in welchem Umfang die maximale Ladekapazität durch die Lagerung verringert wurde. Der dem oberen Grenzwert entsprechende Ladezustand ergibt sich dann bevorzugt als derjenige Anteil an der maximalen Ladekapazität im Ausgangszustand (also vor der Lagerung) für welchen nach der Lagerung noch der größtmögliche Anteil der maximalen Ladekapazität (vor der Lagerung) erreicht werden kann. Der besagte Ladezustand kann dabei in Wh oder in % der maximalen Ladekapazität für die Batteriezelle angegeben werden. Entsprechend kann hieraus der obere Grenzwert ermittelt werden.

Unter einer Aktivierungsroutine für die Langzeit-Lagerung ist insbesondere derjenige Prozess zu verstehen, durch welchen das für Instrument in den Langzeit-Lagerungsmodus versetzt wird. Die Aktivierungsroutine für die Langzeit-Lagerung läuft dabei, nach einer Initialisierung, vorzugsweise automatisch ab. Der Langzeit-Lagerungsmodus wird somit anhand der Aktivierungsroutine für die Langzeit-Lagerung initialisiert, wobei letztere ebenfalls automatisch gestartet werden kann, oder auch durch eine Benutzereingabe in Gang gesetzt werden kann. Für die Aktivierungsroutine der Langzeit-Lagerung wird ein aktuell tatsächlich vorliegender Wert der Kenngröße für den Ladezustand, also der Istwert der Kenngröße gemessen, und mit dem vorgegebenen oberen Grenzwert verglichen, welcher als ein Maximum für einen Ladezustand für eine Langzeit-Lagerung des Hörinstruments entsprechend angesehen wird. Der besagte Vergleich kann dabei beispielsweise durch eine Schaltung zum Energie-Management (Power Management Integrated Circuit, PWIC) durchgeführt werden, oder durch einen Rechenprozess auf einer Prozessoreinheit des Hörinstruments, welche dort für eine Erzeugung eines akustischen Ausganssignals vorgesehen und eingerichtet ist.

Liegt nun der gemessene Istwert der Kenngröße über dem für den Langzeit-Lagerungsmodus vorgesehenen und entsprechend vorgegebenen oberen Grenzwert, und ist also entsprechend der tatsächlich vorliegende Ladezustand über dem für die Langzeit-Lagerung als maximal angesehenem Ladezustand, wird die Batteriezelle wenigstens bis so weit entladen, bis der Istwert der Kenngröße infolge des verringerten Ladezustands den oberen Grenzwert erreicht (und somit die Batteriezelle den für die Langzeit-Lagerung als maximal angesehenen Ladezustand nicht mehr überschreitet). Eine derartige Entladung kann beispielsweise dadurch erfolgen, dass das für Instrument in einen Stand-by-Betrieb oder einen erweiterten Stand-by-Betrieb oder einen Normal-Betrieb (unter Nutzung aller üblichen Funktionen wenigstens der Prozessoreinheit) versetzt wird, sodass durch die kontinuierliche Leistungsentnahme während dieses besagten Betriebs der Ladezustand der Batteriezelle nach und nach verringert wird. Gegebenenfalls kann der oder jeder elektro-akustische Ausgangswandler des Hörinstruments für den Vorgang des Entladens deaktiviert werden, sodass am Ort der Lagerung (beispielsweise eine Schublade o.ä.) keine ungewünschten Geräusche erzeugt werden, und das Entladen vorrangig über die Leistung für die Prozessoreinheit erreicht wird. Dies erlaubt dem Benutzer, nach einem Starten der Aktivierungsroutine der Langzeit-Lagerung das Hörinstrument bereits am vorgesehenen Ort für die Langzeit-Lagerung anzuordnen bzw. unterzubringen.

Erfolgt ein Vergleich des gemessenen Istwertes der Kenngröße für den Ladezustand der Batteriezelle mit dem vorgegebenen oberen Grenzwert für die Kenngrö-ße lediglich in diskreten Schritten (sei es aus Gründen der Digitalisierung der gemessenen Kenngröße, also z.B. einer Spannung, oder infolge einer Digitalisierung und somit Diskretisierung des entsprechenden Istwertes), sollte bevorzugt eine Entladung der Batteriezelle erfolgen, bis der Istwert der Kenngröße nicht mehr über dem vorgegebenen oberen Grenzwert liegt, und somit bei besagten Diskretisierung gegebenenfalls auch inkremental den oberen Grenzwert unterschreitet (und somit sichergestellt ist, dass der tatsächlich vorliegende Ladezustand nicht mehr den für die Langzeit-Lagerung als maximal angesehenen Ladezustand überschreitet). Sobald dies der Fall ist, wird das Hörinstrument in den Langzeit-Lagerungsmodus versetzt.

Der Langzeit-Lagerungsmodus ist hierbei insbesondere so zu konfigurieren, dass eine weitere Energieentnahme aus der Batteriezelle während der langfristigen Lagerung und auch sonstige Kriechströme o.ä. möglichst unterbunden werden, um zum einen den verfügbaren Ladezustand für eine erneute Verwendung nach der langzeitigen Lagerung möglichst hoch zu halten, und zum anderen das Risiko für eine Tiefenentladung möglichst zu minimieren. Dies kann insbesondere dadurch erfolgen, dass die Batteriezelle hierfür von der PWIC getrennt wird, und gegebenenfalls nur mit einer Schutzschaltung zum Schutz vor Tiefenentladung und/oder Kurzschlüssen verbunden bleibt.

Das genannte Verfahren erlaubt es, dass Hörinstrument auch nach einer Auslieferung an den Benutzer und insbesondere nach einer Inbetriebnahme durch den Benutzer in einen Zustand zu versetzen, in welchem eine langfristige Lagerung über mehrere Wochen oder gar Monate für das Hörinstrument ohne drohende Beschädigung oder nachhaltige Verschlechterung der Batteriezelle des Hörinstruments möglich ist.

Bevorzugt wird für den Fall, dass der gemessene Istwert der Kenngröße für den Ladezustand der Batteriezelle unterhalb des oberen Grenzwertes für die Kenngröße liegt, das Hörinstrument in den Langzeit-Lagerungsmodus versetzt. Dies bedeutet insbesondere, dass im Rahmen der Aktivierungsroutine der Langzeit-Lagerung kein Entladen erforderlich ist, wenn zu Beginn der besagten Aktivierungsroutine ermittelt wird, dass der Istwert der Kenngröße für den Ladezustand bereits unter dem vorgegebenen oberen Grenzwert liegt (und entsprechend der vorliegende Ladezustand für eine Langzeit-Lagerung nicht unzulässig hoch ist). Das Hörinstrument kann stattdessen ohne Entladevorgang der Batteriezelle unmittelbar in den Langzeit-Lagerungsmodus versetzt werden.

Bevorzugt wird für die Langzeit-Lagerung des Hörinstruments ein unterer Grenzwert der Kenngröße für den Ladezustand der wiederaufladbaren Batteriezelle vorgegeben, wobei für den Fall, dass der gemessene Istwert der Kenngröße für den Ladezustand der Batteriezelle unter dem unteren Grenzwert für die Kenngröße liegt, eine Aufforderung zu einem Aufladen der Batteriezelle an einen Benutzer des Hörinstruments ausgegeben. Die Aufforderung kann dabei insbesondere in akustischer Form als ein entsprechender Signalton oder eine Nachricht über den Ausgangswandler des Hörinstruments ausgegeben werden, aber insbesondere auch über eine mit dem Hörinstrument verbindbare Hilfsvorrichtung angezeigt werden.

Günstigerweise wird dabei für den Fall, dass der gemessene Istwert der Kenngrö-ße für den Ladezustand der Batteriezelle zwischen dem oberen Grenzwert und dem unteren Grenzwert für die Kenngröße liegt, das Hörinstrument in den Langzeit-Lagerungsmodus versetzt. Dies bedeutet insbesondere, dass für den Langzeit-Lagerungsmodus kein voriger Entladevorgang erfolgt.

Vorzugsweise wird die Aktivierungsroutine der Langzeit-Lagerung durch den Benutzer des Hörinstruments mittels einer Benutzereingabe initiiert. Dies erlaubt dem Benutzer einen effizienten Schutz der Batteriezelle, wenn er vorhat, das Hörinstrument langfristig nicht zu verwenden und entsprechend aufzubewahren. Insbesondere wird die Benutzereingabe über eine entsprechende Applikation vom Benutzer des Hörinstruments mittels einer Hilfsvorrichtung wie z.B. ein Smartphone oder eine Smartwatch eingegeben, welche mit dem Hörinstrument datentechnisch verbindbar ist.

Bevorzugt wird die Aufforderung zu einem Aufladen der Batteriezelle mittels der Hilfsvorrichtung an den Benutzer des Hörinstruments ausgegeben, also z.B. als entsprechende Anzeige über einen Bildschirm.

Erfindungsgemäß wird wiederholt und bevorzugt mit einer ersten Periodizität eine Nutzung des Hörinstruments überprüft, wobei die Aktivierungsroutine der Langzeit-Lagerung automatisch initiiert wird, sobald für wenigstens eine erste Zeitdauer keine Nutzung des Hörgerätes erfolgt ist. Die Nutzung des Hörgerätes wird dabei automatisch und insbesondere durch das Hörinstrument (z.B. als Funktion auf der Prozessoreinheit) selbst überprüft. Dies ermöglicht eine Initialisierung des Langzeit-Lagerungsmodus auch dann, wenn der Benutzer die Aktivierungsroutine der Langzeit-Lagerung nicht selbst in Gang gesetzt hat, z.B. infolge von Vergessen. Die erste Zeitdauer kann dabei bevorzugt einen Zeitraum von drei Tagen bis zwei Monaten, besonders bevorzugt bis einen Monat betragen.

Zweckmäßigerweise wird außerhalb der Aktivierungsroutine der Langzeit-Lagerung wiederholt und bevorzugt mit einer zweiten Periodizität der gemessene Istwert der Kenngröße für den Ladezustand der Batteriezelle mit dem vorgegebenen unteren Grenzwert für die Kenngröße verglichen, wobei für den Fall, dass der gemessene Istwert unter dem unteren Grenzwert liegt, eine Aufforderung zu einem Aufladen der Batteriezelle an den Benutzer des Hörinstruments ausgegeben wird. Dies soll insbesondere sicherstellen, dass die Batteriezelle grundsätzlich hinreichend aufgeladen ist, um auch dann in den Langzeit-Lagerungsmodus übergehen zu können, wenn dessen Initialisierung automatisch nach einer entsprechend erkannten längeren Nichtbenutzung des Hörinstruments erfolgt. Die erste Zeitdauer kann dabei bevorzugt einen Zeitraum von drei Tagen bis zwei Monaten, besonders bevorzugt bis zwei Wochen betragen.

So kann z.B. eine Nutzung des Hörinstruments und zugleich der Ladezustand der Batteriezelle überprüft werden. Liegt der Istwert über dem unteren Grenzwert (und entsprechend der tatsächliche Ladezustand über einem für die Langzeit-Lagerung als minimal angesehen Ladezustand), und liegt keine Nutzung des Hörinstruments vor, so kann zumindest bis zu einer weiteren Überprüfung gewartet werden, ohne eine Anweisung an den Benutzer zum Laden der Batteriezelle auszugeben, da im Fall, dass auch bei der nächsten Überprüfung keine Nutzung vorliegt, die Aktivierungsroutine der Langzeit-Lagerung infolge des vermutlich weiterhin ausreichenden Ladezustands immer noch automatisch initiiert werden könnte.

Bevorzugt wird das Hörinstrument für das Versetzen in den Langzeit-Lagerungsmodus abgeschaltet. Dies bedeutet insbesondere, dass keinerlei Funktionen in der Prozessoreinheit des Hörinstruments durchgeführt werden, und ggf. auch ein Betriebssystem nicht mehr in einem Arbeitsspeicher der Prozessoreinheit geladen ist, sodass die Prozessoreinheit keinerlei Energieverbrauch mehr aufweist (ggf. bis auf ungewünschte Kriechströme). Dadurch bleibt der Ladestand der Batteriezelle im Langzeit-Lagerungsmodus besonders stabil. Insbesondere ist auch eine Kommunikationseinrichtung des Hörinstruments spannungslos geschaltet.

Zweckmäßigerweise wird dabei die Batteriezelle für das Versetzen in den Langzeit-Lagerungsmodus von der PWIC des Hörinstruments schaltungstechnisch getrennt. Hierdurch können auch unerwünschte Kriechströme, insbesondere in die Prozessoreinheit, weitestmöglich unterbunden werden. Derartige Kriechströme können bei einer Batteriezelle, welche z.B. für eine mittlere Abgabe von 20mA ausgelegt ist, bis zu 4µA betragen.

Bevorzugt ist die Batteriezelle im Langzeit-Lagerungsmodus mit einer Batterie-Schutzschaltung, insbesondere zum Schutz vor einer Tiefenentladung und/oder vor Kurzschlüssen, verbunden. Ist die Batteriezelle auch im Normalbetrieb mit einer derartigen Schutzschaltung verbunden, bleibt die Verbindung auch im Langzeit-Lagerungsmodus erhalten. Liegt eine derartige Verbindung zur Schutzschaltung im Normalbetrieb nicht vor, so wird sie als Teil der Initialisierung des Langzeit-Lagerungsmodus hergestellt. Mögliche Kriechströme, die sich hieraus ergeben, sind infolge der Architektur der Schutzschaltung nahezu vernachlässigbar, und können z.B. für eine Batteriezelle, die auf eine mittlere Abgabe von 20mA ausgelegt ist, auf 40 nA begrenz werden.

Günstigerweise wird als Kenngröße für den Ladezustand der Batteriezelle eine an der Batteriezelle anliegende Spannung gemessen bzw. vorgegeben. Dies bedeutet insbesondere, dass als oberer und ggf. unterer Grenzwert ein entsprechender Spannungswert vorgegeben wird, und als Istwert ein Wert der an der Batteriezelle anliegenden Spannung gemessen wird. Eine Spannungsmessung lässt sich technisch besonders einfach realisieren, und erfordert üblicherweise auch keine zusätzlichen, eigens dafür vorgesehenen Komponenten im Hörinstrument. Bevorzugt wird dabei die an der Batteriezelle anliegende Spannung mithilfe eines Analog-Digital-Wandlers ermittelt.

In einer vorteilhaften Ausgestaltung wird im Rahmen der Aktivierungsroutine der Langzeit-Lagerung für ein Entladen der Batteriezelle wenigstens so weit, bis die Kenngröße für den Ladezustand den oberen Grenzwert erreicht, eine Kommunikationseinrichtung und/oder ein Ausgangswandler des Hörinstruments des Hörinstruments deaktiviert, unter einer Kommunikationseinrichtung ist hierbei insbesondere eine Antenne für eine Bluetooth- und/oder WLAN-Verbindung vorgesehen. Ein Abschalten der Kommunikationseinrichtung erlaubt es, das Hörinstrument für die Langzeit-Abschalt-Routine und ggf. auch für den Langzeit-Lagerungsmodus in einem Ladegerät für das Hörinstrument aufzubewahren, ohne dass es hierbei zu Störungen für das Ladegerät kommen kann. Ggf. wird für das Ladegerät hierzu ein Lademodus deaktiviert, um ein ungewünschtes Laden zu unterbinden. Nachfolgend wird ein Ausführungsbeispiel der Erfindung anhand von Zeichnungen näher erläutert. Hierbei zeigen jeweils schematisch:
- Fig. 1: in einem Blockschaltbild ein als ein Hörgerät ausgestaltetes Hörinstrument,
- Fig. 2: ein Blockdiagramm eines illustratives Verfahrens, um das Hörgerät nach Fig. 1 in einen Langzeit-Lagerungsmodus zu versetzen, und
- Fig. 3: eine erfindungsgemäße Alternative des Verfahrens zur Initialisierung des Langzeit-Lagerungsmodus nach Fig. 2.

Einander entsprechende Teile und Größen sind in allen Figuren jeweils mit denselben Bezugszeichen versehen.

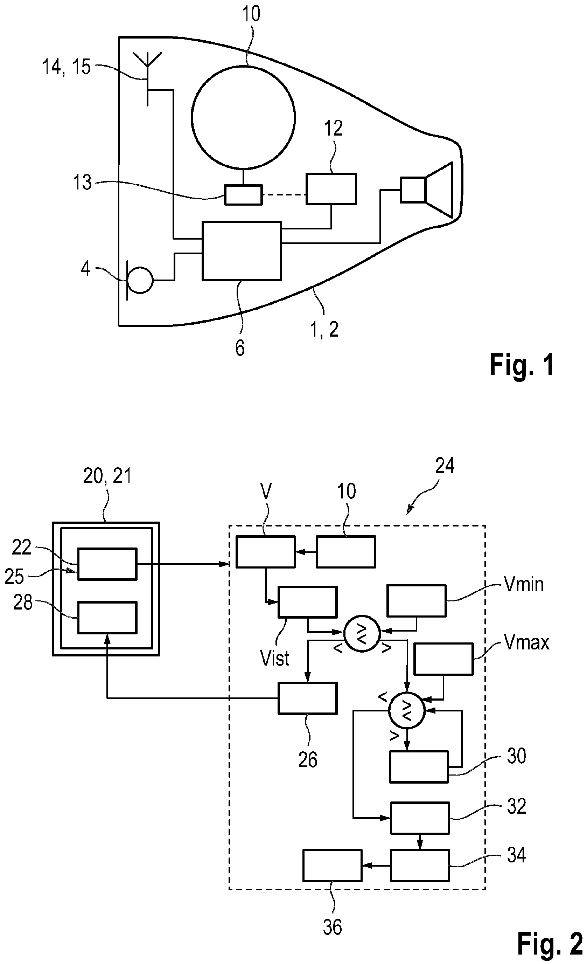

In Figur 1 ist schematisch in einem Blockschaltbild ein Hörinstrument 1 dargestellt, welches vorliegend durch ein Hörgerät 2 gegeben ist. Das Hörgerät 2 weist ein Mikrofon 4 auf, welches dazu eingerichtet ist, aus einem Schallsignal einer Umgebung des Hörgerätes 2 ein entsprechendes elektrisches Eingangssignal (nicht dargestellt) zu erzeugen. Das Mikrofon 4 ist verbunden mit einer Prozessoreinheit 6, welche insbesondere einen Signalprozessor mit wenigstens einem Prozessorkern und einen durch den Prozessorkern adressierbaren Arbeitsspeicher (jeweils nicht näher dargestellt) aufweist. Insbesondere ist auf der Prozessoreinheit 6 auch ein nicht-flüchtiger Speicher implementiert, auf welchem Grundfunktionen, Betriebsprogramme und -modi des Hörgerätes 2 für den Betrieb abgespeichert sind. Das besagte, vom Mikrofon 4 erzeugte Eingangssignal wird in der Prozessoreinheit 6 entsprechend den audiologischen Anforderungen des Benutzers des Hörgerätes 2 zum Ausgleich der Hörschwäche verarbeitet, und dabei insbesondere frequenzabhängig verstärkt bzw. komprimiert. Hierbei wird in der Prozessoreinheit 6 ein Ausgangssignal erzeugt, welches an einen elektro-akustischen Ausgangswandler 8 des Hörgerätes 2 ausgegeben wird, der hierzu entsprechend mit der Prozessoreinheit 6 verbunden ist. Der elektro-akustische Ausgangswandler 8 ist vorliegend gegeben durch einen Lautsprecher, und wandelt das durch die Prozessoreinheit 6 erzeugte Ausgangssignal in ein entsprechendes Ausgangsschallsignal um (nicht dargestellt), welches dem Gehör des Benutzers des Hörgerätes 2 zugeführt wird.

Für den Betrieb weist das Hörgerät 2 eine wiederaufladbare Batteriezelle 10 auf, welche vorliegend gegeben ist durch eine Lithium-Ionen-Zelle. Die Batteriezelle 10 ist über eine Schutzschaltung 13 verbunden mit der PMIC 12, welche für Funktionen des Batterie-Management, einer Spannungsregelung, eines Leistungsflusses und eines Ladens der Batteriezelle 10 eingerichtet ist. Die Verbindung der Batteriezelle 10 mit der PMIC 12 ist hierbei insbesondere derart ausgestaltet, dass die Batteriespannung, welche an den beiden Polen der Batteriezelle 10 anliegt, abgreifbar und insbesondere messbar ist. Die Verbindung der PMIC 12 mit der Schutzschaltung 13 (gestrichelt dargestellt) kann zudem durch die PMIC 12 unterbrochen werden (z.B. über eine entsprechende Schaltlogik).

Die PMIC 12 ist verbunden mit der Prozessoreinheit 6, um diese für die Signalverarbeitung mit Energie zu versorgen. Eine Energieversorgung des Ausgangswandlers 8 kann dabei insbesondere über die Prozessoreinheit 6 erfolgen, der Ausgangswandler 8 kann jedoch auch gesondert seine Leistung zur Erzeugung des Ausgangsschallsignal direkt von der PMIC 12 beziehen (nicht dargestellt). Das Hörgerät 2 weist zudem eine Kommunikationseinrichtung 14 auf, welche vorliegend als eine Bluetooth-fähige Antenne 15 gegeben ist, die mit der Prozessoreinheit 6 verbunden ist, und die dazu eingerichtet ist, eine Verbindung zu einer externen Hilfsvorrichtung (nicht dargestellt) wie einem Smartphone oder auch zu einem weiteren Hörgerät (nicht dargestellt) im Fall eines binauralen Hörgerätesystems herzustellen. Die Antenne 15 ist hierfür mit der Prozessoreinheit 6 verbunden, um ein entsprechendes Sendesignal (nicht dargestellt) von dieser zu empfangen. Die Energieversorgung der Antenne 15 erfolgt ebenfalls über die Prozessoreinheit 6.

Im Fall, dass der Benutzer des Hörgerätes 2 dieses nach einer Inbetriebnahme für einen längeren Zeitraum lagern möchte, sodass insbesondere keinerlei Betrieb des Hörgerätes 2 erfolgt, wird das Hörgerät 2 in noch zu beschreibender Weise in einen entsprechenden Langzeit-Lagerungsmodus versetzt. Dieser Langzeit-Lagerungsmodus ist insbesondere dadurch charakterisiert, dass ein Ladezustand der Batteriezelle 10 auf einen Wert eingestellt wird, welcher für eine langfristige Lagerung des Hörgerätes 2 (und somit für eine langen Zeitraum ohne ein Laden und ohne nennenswertes Entladen der Batteriezelle 10 über Kriechströme hinaus) dahingehend optimiert ist, dass nach einer Beendigung der Lagerung, zum Beispiel nach einigen Wochen oder gar Monaten, die Batteriezelle 10 eine möglichst hohe Ladekapazität beibehält.

In Figur 2 ist schematisch in einem Blockdiagramm ein Verfahren dargestellt, mittels dessen das Hörgerät 2 nach Figur 1 in eine Langzeit-Lagerungsmodus versetzt werden kann. Ein Benutzer (nicht dargestellt) gibt über eine Hilfsvorrichtung 20, welche vorliegend als ein Smartphone 21 ausgestaltet ist (auch eine Ausgestaltung als Smartwatch, Tablet o.ä. ist ebenso denkbar), und welche mit dem Hörgerät 2 nach Figur 1 über dessen Antenne 15 verwendbar ist, einen Befehl 22 zur Initiierung einer Aktivierungsroutine 24 der Langzeit-Lagerung an das Hörgerät 2. Dies kann beispielsweise dadurch erfolgen, dass auf dem Smartphone 21 eine App 25 implementiert ist, welche zur Steuerung bestimmter Funktionen des Hörgerätes 2 und insbesondere zur Befehlseingabe des Befehls 22 eingerichtet ist, sodass dieser entsprechend an das Hörgerät 2 weitergegeben wird. Im Hörgerät 2 wird entsprechend die Aktivierungsroutine 24 der Langzeit-Lagerung in Gang gesetzt.

Hierfür wird eine an der Batteriezelle 10 anliegende Spannung V als eine Kenngröße für den Ladezustand der Batteriezelle 10 herangezogen. Zunächst wird ein tatsächlich vorhandener Istwert Vist der an der Batteriezelle 10 anliegenden Spannung V ermittelt. Dieser Istwert Vist wird verglichen mit einem vorgegebenen unteren Grenzwert Vmin für die Spannung V als Kenngröße des Ladezustands der Batteriezelle, wobei der untere Grenzwert Vmin derart vorgegeben wird, dass infolge des dem unteren Grenzwertes Vmin entsprechenden Ladezustands der Batteriezelle 10 bei einer längerfristigen Lagerung eine Tiefenentladung, welche die Batteriezelle 10 vollständig beschädigen könnte, wirksam unterbunden wird.

Wird nun festgestellt, dass der anhand der Spannung V gemessene Istwert Vist der Spannung V unter dem vorgegebenen unteren Grenzwert Vmin liegt, und entsprechend der Ladezustand der Batteriezelle 10 unter dem für die langfristige Lagerung des Hörgerätes 2 als minimal angesehenen Ladezustand liegt (welcher dem unteren Grenzwert Vmin für die Spannung V entspricht), so wird eine entsprechende Ladenachricht 26 vom Hörgerät 2 an das Smartphone 21 übertragen, und daraufhin dem Benutzer durch das Smartphone 21 eine Aufforderung 26 zur einem Aufladen der Batteriezelle 10 über den Bildschirm ausgegeben. Die Ausgabe kann insbesondere im Rahmen der App 25 erfolgen, welche zur Steuerung des Hörgerätes 2 auf dem Smartphone 21 installiert und implementiert ist.

Ist jedoch der gemessene Istwert Vist der Kenngröße für den Ladezustand - also der Spannung V - größer als der vorgegebene untere Grenzwert Vmin, so erfolgt ein weiterer Vergleich des gemessenen Istwertes Vist mit einem vorgegebenen oberen Grenzwert Vmax für die Spannung V. Dieser obere Grenzwert Vmax für die Spannung wird derart vorgegeben, dass infolge des dem oberen Grenzwert Vmax entsprechenden Ladezustands der Batteriezelle 10 bei einer längerfristigen Lagerung eine Verschlechterung der dauerhaften Ladekapazität möglichst minimiert wird.

Liegt nun der gemessene Istwert Vist der Spannung V unter dem vorgegebenen oberen Grenzwert Vmax (und somit der tatsächliche Ladezustand der Batteriezelle 10 über dem für die Langzeit-Lagerung maximal als zulässig erachteten Ladezustand), so wird ein Abschalten 32 des Hörgerätes 2 vorgenommen. Dieses Abschalten 32 beinhaltet insbesondere ein Trennen der Prozessoreinheit 6, und, falls gesondert erforderlich, auch der weiteren Verbraucher von der PMIC 12. Anschließend erfolgt eine Trennung 34 der Batteriezelle 10 von der PMIC 12. Diese Trennung 34 erfolgt dabei derart über die Schutzschaltung 13, dass die Batteriezelle 10 daraufhin nur noch mit der Schutzschaltung 13 nach Figur 1 verbunden ist. Die Schutzschaltung 13 ist dazu eingerichtet, während der Langzeit-Lagerung des Hörgerätes 2 die Batteriezelle 10 zusätzlich vor Kurzschlüssen oder auch vor Tiefenentladungen zu schützen, und weist, insbesondere im Vergleich zur PMIC 12, vernachlässigbare Kriegsströme auf. Nach der Trennung 34 der Batteriezelle 10 von der PMIC 12 und dem Abschalten 32 des Hörgerätes 2 ist vorliegend der Langzeit-Lagerungsmodus 36 für das Hörgerät 2 erreicht.

Liegt der gemessene Istwert Vist der Spannung V hingegen über dem vorgegebenen oberen Grenzwert Vmax, so erfolgt ein Entladen 30 der Batteriezelle 10. Das Entladen 30 erfolgt dabei unter einer fortlaufenden oder wiederholten Überprüfung des jeweiligen Istwertes Vist der Spannung V zum jeweiligen Zeitpunkt im Vergleich zum vorgegebenen oberen Grenzwert Vmax. Wird durch den Istwert Vist der obere Grenzwert Vmax erreicht (bzw. liegt der Istwert Vist nicht mehr über dem oberen Grenzwert Vmax), so wird das oben beschriebene Abschalten 32 des Hörgerätes 2 vorgenommen.

Durch die im Hörgerät 2 wie beschrieben vorgenommenen Maßnahmen kann erreicht werden, dass die Batteriezelle 10 bei einer langfristigen Lagerung des Hörgerätes 2 insbesondere über mehrere Monate in einem hierfür hinsichtlich der Beibehaltung der Ladekapazität optimierten (maximalen) Ladezustand gelagert wird (diesem maximalen Ladezustand entspricht der obere Grenzwert Vmax der Spannung V). Zusätzlich wird eine schleichende Entladung durch Kriechströme weitestmöglich unterbunden, sodass der tatsächliche Ladezustand während der Lagerung dauerhaft über einem hinsichtlich einer Tiefenentladung als minimal vorgegebenen Ladezustand gehalten werden kann (welchem der untere Grenzwert Vmin der Spannung V entspricht).

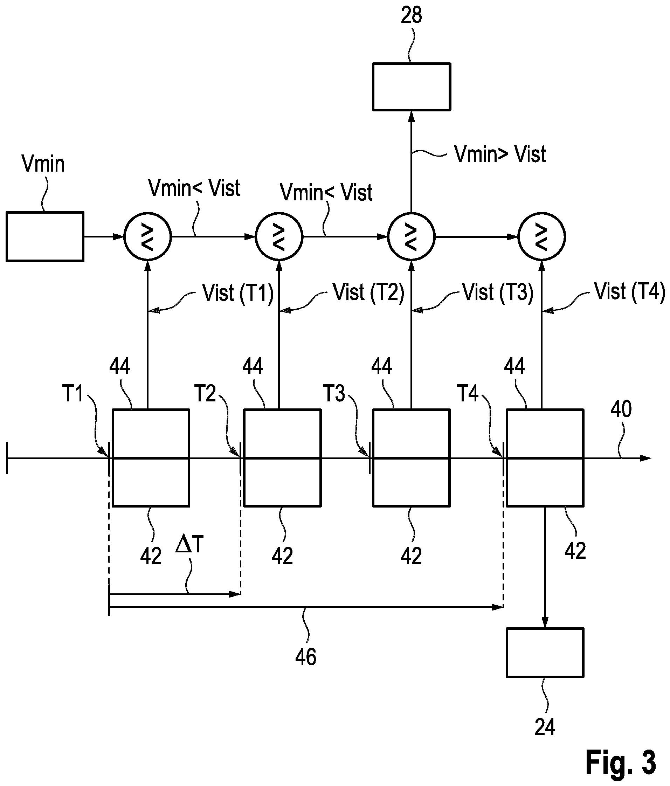

In Figur 3 ist schematisch entlang eines Zeitstrahls 40 eine alternative und erfindungsgemäße Ausgestaltung des Verfahrens nach Figur 2 dargestellt, in welcher die Aktivierungsroutine 24 der langzeit-Lagerung automatisch initiiert wird. Zu Zeitpunkten T1, T2, T3, T4 mit einer Periodizität ΔT erfolgt hierzu in dieser Ausgestaltung durch das Hörgerät 2 selbst eine automatische Überprüfung 42 einer Nutzung des Hörgerätes 2. Zeitgleich erfolgt ebenfalls eine Überprüfung 44 des Istwertes Vist der an der Batteriezelle 10 anliegenden Spannung V, wie sie anhand von Fig. 2 beschrieben ist.

Der zu den einzelnen Zeitpunkten T1, T2, T3, T4 ermittelte Istwert Vist der Spannung V wird jeweils mit dem für eine Langzeit-Lagerung vorgegebenen unteren Grenzwert Vmin verglichen. Liegt bei den Überprüfungen 44 des Istwertes Vist dieser stets über dem unteren Grenzwert Vmin (also Vmin < Vist), so erfolgt keine weitere Aktion. Liegt jedoch zu einem der Zeitpunkte, beispielsweise zum Zeitpunkt T3, der gemessene Istwert Vist der an der Batteriezelle 10 anliegenden Spannung V, welche ja die Kenngröße für den Ladezustand der Batteriezelle 10 bildet, unter dem für die Langzeit-Lagerung vorgegebenen, unteren Grenzwert Vmin für die Spannung V (also Vmin > Vist), so wird die Aufforderung 28 zum Laden des Hörgerätes 2 ausgegeben, wie anhand von Figur 2 dargestellt.

Wird zudem mindestens für eine erste Zeitdauer 46, welche vorliegend beispielhaft der Zeitspanne von T1 bis T4 = 3·ΔT entsprechen soll (jedoch auch einen anderen, von Fachmann geeignet zu wählenden Zeitraum umfassen kann), bei der Überprüfung 42 keinerlei Nutzung des Hörgerätes 2 festgestellt, so wird automatisch die Aktivierungsroutine 24 der Langzeit-Lagerung nach Figur 2 initiiert. Hierbei ist insbesondere die wiederholte Überprüfung 44 des Istwertes Vist der Spannung V von Vorteil, da davon auszugehen ist, dass der Benutzer bei einer regelmäßigen Nutzung des Hörgerätes 2 die Aufforderung 28 zum Laden im Fall, dass der Istwert Vist unter dem unteren Grenzwert Vmin liegt, empfangen und auch entsprechend umsetzen wird. Selbst bei einer Nichtbenutzung über die erste Zeitdauer 46, welche gemäß dem vorliegenden Ausführungsbeispiel die automatische Initiierung der Aktivierungsroutine 24 der Langzeit-Lagerung zur Folge hat, darf daher davon ausgegangen werden, dass der Istwert Vist den vorgegebenen unteren Grenzwert Vmin zumindest nicht unterschreitet (und somit der tatsächliche Ladezustand der Batteriezelle 10 den für die Langzeit-Lagerung als minimal angesehenen Ladezustand, welcher dem unteren Grenzwert Vmin entsprich, nicht unterschreitet), sodass in der Aktivierungsroutine 24 der Langzeit-Lagerung gemäß Figur 2 der Langzeit-Lagerungsmodus 36 auch tatsächlich erreicht werden kann.

Die Überprüfung 44 des Istwertes Vist der Spannung V kann auch zu unterschiedlichen Zeitpunkten als die Überprüfung 42 der Nutzung des Hörgerätes 2 erfolgen. Dies kann insbesondere in Abhängigkeit der Nutzungsgewohnheiten des Benutzers des Hörgerätes 2 entsprechend eingestellt werden. Eine zeitgleiche Überprüfung hat jedoch den Vorteil, dass nur ein periodischer Prozess für beide Überprüfungen 42, 44 zu implementieren ist.

In den vorangegangenen Ausführungsbeispielen ist das Hörinstrument 1 als ein Hörgerät 2 ausgestaltet, welches zur Versorgung einer Hörschwäche seines Benutzers vorgesehen und eingerichtet ist. Eine andere Ausgestaltung ist jedoch ohne weiteres möglich. So kann das Hörinstrument 1 nach Figur 1 durch einen Ohrstöpsel-förmigen Kopfhörer gegeben sein, wobei über das Mikrofon 4 Sprachbefehle des Benutzers zur Ansteuerung von Funktionen des Kopfhörers aufgenommen und in der Prozessoreinrichtung 6 (aus dem zugehörigen Eingangssignal) entsprechend erkannt und verarbeitet werden. Ebenso sind auch Ausgestaltungen eines Hörinstruments 1 ohne ein Mikrofon denkbar.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, welche in den folgenden Ansprüchen definiert ist.

### Bezugszeichenliste

- 1: Hörinstrument
- 2: Hörgerät
- 4: Mikrofon
- 6: Prozessoreinheit
- 8: Ausgangswandler
- 10: Batteriezelle
- 12: PMIC
- 13: Schutzschaltung
- 14: Kommunikationseinrichtung
- 15: Antenne
- 20: Hilfsvorrichtung
- 21: Smartphone
- 22: Befehl
- 24: Aktivierungsroutine der Langzeit-Lagerung
- 25: App, Applikation
- 26: Ladenachricht
- 28: Aufforderung zum Laden
- 30: Entladen
- 32: Abschaltung
- 34: Trennung
- 36: Langzeit-Lagerungsmodus
- 40: Zeitstrahl
- 42: Überprüfung (der Nutzung)
- 44: Überprüfung (des Istwertes)

- Vist: Istwert der Spannung
- Vmax: oberer Grenzwert der Spannung
- Vmin: unterer Grenzwert der Spannung
- T1-T4: Zeitpunkte
- V: Spannung

## Patentansprüche

1. Verfahren zur Initialisierung eines Langzeit-Lagerungsmodus (36) für ein Hörinstrument (1), welches eine wiederaufladbare Batteriezelle (10) aufweist, wobei für eine Langzeit-Lagerung des Hörinstruments (1) ein oberer Grenzwert (Vmax) einer Kenngröße (V) für einen Ladezustand der wiederaufladbaren Batteriezelle (10) vorgegeben wird,
wobei im Rahmen einer Aktivierungsroutine (24) der Langzeit-Lagerung
- ein tatsächlich vorhandener Istwert (Vist) der Kenngröße (V) für den Ladezustand der Batteriezelle (10) gemessen wird,
- der gemessene Istwert (Vist) der Kenngröße (V) für den Ladezustand der Batteriezelle (10) mit dem oberen Grenzwert (Vmax) der Kenngröße (V) für den Ladezustand verglichen wird, und
- für den Fall, dass der gemessene Istwert (Vist) der Kenngröße (V) über dem oberen Grenzwert (Vmax) für die Kenngröße (V) liegt, die Batteriezelle (10) wenigstens soweit entladen (30) wird, bis die Kenngröße (V) für den Ladezustand den vorgegebenen oberen Grenzwert (Vmax) erreicht hat, und das Hörinstrument (1) in einen Langzeit-Lagerungsmodus (36) versetzt wird,
**dadurch gekennzeichnet, dass**
- wiederholt eine Nutzung des Hörinstruments (1) überprüft (42) wird, und
- die Aktivierungsroutine (24) der Langzeit-Lagerung automatisch initiiert wird, sobald für wenigstens eine erste Zeitdauer (46) keine Nutzung des Hörgerätes (1) erfolgt ist.

2. Verfahren nach Anspruch 1,
wobei für den Fall, dass der gemessene Istwert (Vist) der Kenngröße (V) für den Ladezustand der Batteriezelle (10) unterhalb des oberen Grenzwertes (Vmax) für die Kenngröße liegt, das Hörinstrument (1) in den Langzeit-Lagerungsmodus (36) versetzt wird.

3. Verfahren nach Anspruch 1 oder Anspruch 2,
wobei für die Langzeit-Lagerung des Hörinstruments (1) ein unterer Grenzwert (Vmin) der Kenngröße (V) für den Ladezustand der wiederaufladbaren Batteriezelle (10) vorgegeben wird, und
wobei für den Fall, dass der gemessene Istwert (Vist) der Kenngröße (V) für den Ladezustand der Batteriezelle (10) unter dem unteren Grenzwert (Vmin) für die Kenngröße (V) liegt, eine Aufforderung (28) zu einem Aufladen der Batteriezelle (10) an einen Benutzer des Hörinstruments (1) ausgegeben wird.

4. Verfahren nach Anspruch 3 in Verbindung mit Anspruch 2,
wobei für den Fall, dass der gemessene Istwert (Vmax) der Kenngröße (V) für den Ladezustand der Batteriezelle (10) zwischen dem oberen Grenzwertes (Vmax) und dem unteren Grenzwert für die Kenngröße (V) liegt, das Hörinstrument (1) in den Langzeit-Lagerungsmodus (36) versetzt wird.

5. Verfahren nach einem der vorhergehenden Ansprüche,
wobei die Aktivierungsroutine (24) der Langzeit-Lagerung durch den Benutzer des Hörinstruments (1) mittels einer Benutzereingabe initiiert wird.

6. Verfahren nach Anspruch 5,
wobei die Benutzereingabe über eine entsprechende Applikation (25) vom Benutzer des Hörinstruments (1) mittels einer Hilfsvorrichtung (20) eingegeben wird, welche mit dem Hörinstrument (1) datentechnisch verbindbar ist.

7. Verfahren nach Anspruch 6,
wobei die Aufforderung (28) zu einem Aufladen der Batteriezelle (10) mittels der Hilfsvorrichtung (20) an den Benutzer des Hörinstruments (1) ausgegeben wird.

8. Verfahren nach einem der Ansprüche 3 bis 7,
wobei außerhalb der Aktivierungsroutine (24) der Langzeit-Lagerung wiederholt der gemessene Istwert (Vist) der Kenngröße (V) für den Ladezustand der Batteriezelle (10) mit dem vorgegebenen unteren Grenzwert (Vmin) für die Kenngröße (V) verglichen wird, und
wobei für den Fall, dass der gemessene Istwert (Vist) unter dem unteren Grenzwert (Vmin) liegt, eine Aufforderung (28) zu einem Aufladen der Batteriezelle (10) an den Benutzer des Hörinstruments (1) ausgegeben wird.

9. Verfahren nach einem der vorhergehenden Ansprüche,
wobei das Hörinstrument (1) für das Versetzen in den Langzeit-Lagerungsmodus (36) abgeschaltet (32) wird.

10. Verfahren nach Anspruch 9,
wobei die Batteriezelle (10) für das Versetzen in den Langzeit-Lagerungsmodus (36) von einer Schaltung zum Energie-Management (12) des Hörinstruments (1) schaltungstechnisch getrennt (34) wird.

11. Verfahren nach Anspruch 9,
wobei die Batteriezelle (10) im Langzeit-Lagerungsmodus (36) mit einer Batterie-Schutzschaltung (13) verbunden ist.

12. Verfahren nach einem der vorhergehenden Ansprüche,
wobei als Kenngröße (V) für den Ladezustand (Vist) der Batteriezelle (10) eine an der Batteriezelle (10) anliegende Spannung (V) gemessen bzw. vorgegeben wird.

13. Verfahren nach Anspruch 12,
wobei die an der Batteriezelle (10) anliegende Spannung (V) mithilfe eines Analog-Digital-Wandlers ermittelt wird.

14. Verfahren nach einem der vorhergehenden Ansprüche,
wobei im Rahmen der Aktivierungsroutine (24) der Langzeit-Lagerung für ein Entladen der Batteriezelle (10) wenigstens so weit, bis die Kenngröße (V) für den Ladezustand den oberen Grenzwert erreicht, eine Kommunikationseinrichtung (14) und/oder ein Ausgangswandler (8) des Hörinstruments (1) deaktiviert wird.

15. Hörinstrument (1), umfassend
- eine wiederaufladbare Batteriezelle (10)
- eine Messeinrichtung zum Messen eines Istwertes (Vist) einer Kenngröße (V) für einen Ladezustand der Batteriezelle (10),
- eine Vergleichseinrichtung zum Vergleich des gemessenen Istwertes (Vist) der Kenngröße (V) mit einem für eine Langzeit-Lagerung des Hörinstruments (1) vorgegebenen oberen Grenzwert (Vmax) der Kenngröße (V) für den Ladezustand der Batteriezelle (10), und
- eine Entladeeinrichtung, welche im Rahmen einer Aktivierungsroutine (24) einer Langzeit-Lagerung des Hörinstruments (1) für den Fall, dass der gemessene Istwert (Vist) für die Kenngröße (V) des Ladezustands der Batteriezelle (10) über dem oberen Grenzwert (Vmax) liegt, dazu eingerichtet ist, die Batteriezelle (10) des Hörinstruments (1) wenigstens so weit zu entladen, bis die Kenngröße (V) für den Ladezustand den oberen Grenzwert (Vmax) erreicht hat,
wobei das Hörinstrument (1) dazu eingerichtet ist, im Rahmen der Aktivierungsroutine (24) der Langzeit-Lagerung bei einem Erreichen des Ladezustands, welcher dem vorgegebenen oberen Grenzwert (Vmax) der Kenngröße (V) entspricht, einen Langzeit-Lagerungsmodus (36) einzunehmen,
**dadurch gekennzeichnet, dass**
das Hörinstrument (1) weiter dazu eingerichtet ist, wiederholt eine Nutzung zu überprüfen (42), und die Aktivierungsroutine (24) der Langzeit-Lagerung automatisch zu initiieren, sobald für wenigstens eine erste Zeitdauer (46) keine Nutzung erfolgt ist.

## Claims

1. Method for initializing a long-term-storage mode (36) for a hearing instrument (1) that exhibits a rechargeable battery cell (10),
wherein for a long-term storage of the hearing instrument (1) an upper limiting value (Vmax) of a parameter (V) for a state of charge of the rechargeable battery cell (10) is predetermined,
wherein within the scope of an activation routine (24) for long-term storage
- an actual value (Vist), actually present, of the parameter (V) for the state of charge of the battery cell (10) is measured,
- the measured actual value (Vist) of the parameter (V) for the state of charge of the battery cell (10) is compared with the upper limiting value (Vmax) of the parameter (V) for the state of charge, and
- in the case where the measured actual value (Vist) of the parameter (V) lies above the upper limiting value (Vmax) for the parameter (V) the battery cell (10) is discharged (30) at least until the parameter (V) for the state of charge has reached the predetermined upper limiting value (Vmax), and the hearing instrument (1) is placed into a long-term-storage mode (36),
**characterized in that**
- a utilization of the hearing instrument (1) is checked (42) repeatedly, and
- the activation routine (24) for long-term storage is initiated automatically as soon as no utilization of the hearing instrument (1) has occurred for at least a first time-period (46).

2. Method according to Claim 1,
wherein in the case where the measured actual value (Vist) of the parameter (V) for the state of charge of the battery cell (10) lies below the upper limiting value (Vmax) for the parameter the hearing instrument (1) is placed into the long-term-storage mode (36).

3. Method according to Claim 1 or Claim 2,
wherein for long-term storage of the hearing instrument (1) a lower limiting value (Vmin) of the parameter (V) for the state of charge of the rechargeable battery cell (10) is predetermined, and
wherein in the case where the measured actual value (Vist) of the parameter (V) for the state of charge of the battery cell (10) lies below the lower limiting value (Vmin) for the parameter (V) a prompt (28) for a recharging of the battery cell (10) is output to a user of the hearing instrument (1).

4. Method according to Claim 3 in conjunction with Claim 2, wherein in the case where the measured actual value (Vmax) of the parameter (V) for the state of charge of the battery cell (10) lies between the upper limiting value (Vmax) and the lower limiting value for the parameter (V) the hearing instrument (1) is placed into the long-term-storage mode (36).

5. Method according to one of the preceding claims, wherein the activation routine (24) for long-term storage is initiated by the user of the hearing instrument (1) by means of a user input.

6. Method according to Claim 5,
wherein the user input is entered by the user of the hearing instrument (1) via an appropriate application (25) by means of an auxiliary device (20) that is capable of being connected to the hearing instrument (1) for data-processing.

7. Method according to Claim 6,
wherein the prompt (28) for a recharging of the battery cell (10) is output to the user of the hearing instrument (1) by means of the auxiliary device (20).

8. Method according to one of Claims 3 to 7,
wherein outside the activation routine (24) for long-term storage the measured actual value (Vist) of the parameter (V) for the state of charge of the battery cell (10) is compared repeatedly with the predetermined lower limiting value (Vmin) for the parameter (V), and
wherein in the case where the measured actual value (Vist) lies below the lower limiting value (Vmin) a prompt (28) for a recharging of the battery cell (10) is output to the user of the hearing instrument (1).

9. Method according to one of the preceding claims,
wherein for the placing into the long-term-storage mode (36) the hearing instrument (1) is switched off (32).

10. Method according to Claim 9,
wherein for the placing into the long-term-storage mode (36) the battery cell (10) is isolated (34) by circuitry from a circuit for power management (12) of the hearing instrument (1) .

11. Method according to Claim 9,
wherein in the long-term-storage mode (36) the battery cell (10) has been connected to a battery-protection circuit (13).

12. Method according to one of the preceding claims,
wherein a voltage (V) applied to the battery cell (10) is measured or predetermined as parameter (V) for the state of charge (Vist) of the battery cell (10).

13. Method according to Claim 12,
wherein the voltage (V) applied to the battery cell (10) is ascertained with the aid of an analog-to-digital converter.

14. Method according to one of the preceding claims,
wherein a communication device (14) and/or an output transducer (8) of the hearing instrument (1) are/is deactivated within the scope of the activation routine (24) for long-term storage for a discharging of the battery cell (10) at least until the parameter (V) for the state of charge reaches the upper limiting value.

15. Hearing instrument (1), encompassing
- a rechargeable battery cell (10)
- a measuring device for measuring an actual value (Vist) of a parameter (V) for a state of charge of the battery cell (10),
- a comparing device for comparing the measured actual value (Vist) of the parameter (V) with an upper limiting value (Vmax), predetermined for a long-term storage of the hearing instrument (1), of the parameter (V) for the state of charge of the battery cell (10), and
- a discharging device which, within the scope of an activation routine (24) for a long-term storage of the hearing instrument (1) in the case where the measured actual value (Vist) for the parameter (V) of the state of charge of the battery cell (10) lies above the upper limiting value (Vmax), has been set up to discharge the battery cell (10) of the hearing instrument (1) at least until the parameter (V) for the state of charge has reached the upper limiting value (Vmax),
wherein the hearing instrument (1) has been set up to assume a long-term-storage mode (36) within the scope of the activation routine (24) for long-term storage upon attaining the state of charge that corresponds to the predetermined upper limiting value (Vmax) of the parameter (V),
**characterized in that**
the hearing instrument (1) has furthermore been set up to repeatedly check (42) a utilization, and to automatically initiate the activation routine (24) for long-term storage as soon as no utilization has occurred for at least a first time-period (46).

## Revendications

1. Procédé d'initialisation d'un mode de stockage à longue durée (36) d'une aide auditive (1) qui comporte une cellule de batterie rechargeable (10),
une valeur limite supérieure (Vmax) d'une grandeur caractéristique (V) d'un état de charge de la cellule de batterie rechargeable (10) étant spécifiée pour le stockage à longue durée de l'aide auditive (1),
dans le cadre d'une routine d'activation (24) du stockage à longue durée,
- une valeur réelle (Vist) réellement existante de la grandeur caractéristique (V) de l'état de charge de la cellule de batterie (10) étant mesurée,
- la valeur réelle mesurée (Vist) de la grandeur caractéristique (V) de l'état de charge de la cellule de batterie (10) étant comparée à la valeur limite supérieure (Vmax) de la grandeur caractéristique (V) de l'état de charge, et
- dans le cas où la valeur réelle mesurée (Vist) de la grandeur caractéristique (V) est supérieure à la valeur limite supérieure (Vmax) de la grandeur caractéristique (V), la cellule de batterie (10) étant déchargée (30) au moins jusqu'à ce que la grandeur caractéristique (V) de l'état de charge ait atteint la valeur limite supérieure spécifiée (Vmax), et l'aide auditive (1) étant placée dans un mode de stockage à longue durée (36),
**caractérisé en ce que**
- l'utilisation de l'aide auditive (1) est vérifiée (42) de manière répétée, et
- la routine d'activation (24) du stockage à longue durée est automatiquement lancée dès qu'aucune utilisation de l'aide auditive (1) n'est effectuée pendant au moins une première durée (46).

2. Procédé selon la revendication 1,
dans le cas où la valeur réelle mesurée (Vist) de la grandeur caractéristique (V) de l'état de charge de la cellule de batterie (10) est inférieure à la valeur limite supérieure (Vmax) de la grandeur caractéristique, l'aide auditive (1) étant placée dans le mode de stockage à long terme (36).

3. Procédé selon la revendication 1 ou la revendication 2,
une valeur limite inférieure (Vmin) de la grandeur caractéristique (V) de l'état de charge de la cellule de batterie rechargeable (10) étant spécifiée pour le stockage à longue durée de l'aide auditive (1), et
dans le cas où la valeur réelle mesurée (Vist) de la grandeur caractéristique (V) de l'état de charge de la cellule de batterie (10) est inférieure à la valeur limite inférieure (Vmin) de la grandeur caractéristique (V), une demande (28) de charger la cellule de batterie (10) étant délivrée à un utilisateur de l'aide auditive (1) .

4. Procédé selon la revendication 3 en relation avec la revendication 2,
dans le cas où la valeur réelle mesurée (Vmax) de la grandeur caractéristique (V) de l'état de charge de la cellule de batterie (10) est située entre la valeur limite supérieure (Vmax) et la valeur limite inférieure de la grandeur caractéristique (V), l'aide auditive (1) étant placée dans le mode de stockage à longue durée (36) .

5. Procédé selon l'une des revendications précédentes,
la routine d'activation (24) du stockage à longue durée étant lancée par l'utilisateur de l'aide auditive (1) à l'aide d'une entrée d'utilisateur.

6. Procédé selon la revendication 5,
l'entrée d'utilisateur étant effectuée par le biais d'une application correspondante (25) par l'utilisateur de l'aide auditive (1) au moyen d'un dispositif auxiliaire (20) qui peut être relié à l'aide auditive (1) par une technique de données.

7. Procédé selon la revendication 6,
la demande (28) de charger la cellule de batterie (10) étant délivrée à l'utilisateur de l'aide auditive (1) au moyen du dispositif auxiliaire (20).

8. Procédé selon l'une des revendications 3 à 7,
en dehors de la routine d'activation (24) du stockage à longue durée, la valeur réelle mesurée (Vist) de la grandeur caractéristique (V) de l'état de charge de la cellule de batterie (10) étant comparée de manière répétée à la valeur limite inférieure spécifiée (Vmin) de la grandeur caractéristique (V), et
dans le cas où la valeur réelle mesurée (Vist) est inférieure à la valeur limite inférieure (Vmin), une demande (28) de charger la cellule de batterie (10) étant délivrée à l'utilisateur de l'aide auditive (1).

9. Procédé selon l'une des revendications précédentes,
l'aide auditive (1) étant éteinte (32) pour être placée dans le mode de stockage à longue durée (36).

10. Procédé selon la revendication 9,
la cellule de batterie (10) étant séparée (34), par une technique de circuit, d'un circuit de gestion d'énergie (12) de l'aide auditive (1) afin de passer dans le mode de stockage à longue durée (36).

11. Procédé selon la revendication 9,
la cellule de batterie (10) étant reliée à un circuit de protection de batterie (13) dans le mode de stockage à longue durée (36).

12. Procédé selon l'une des revendications précédentes,
une tension (V) appliquée à la cellule de batterie (10) étant mesurée ou spécifiée comme grandeur caractéristique (V) de l'état de charge (Vist) de la cellule de batterie (10).

13. Procédé selon la revendication 12,
la tension (V) appliquée à la cellule de batterie (10) étant déterminée à l'aide d'un convertisseur analogique-numérique.

14. Procédé selon l'une des revendications précédentes,
dans le cadre de la routine d'activation (24) du stockage à longue durée, un module de communication (14) et/ou un convertisseur de sortie (8) de l'aide auditive (1) étant désactivés afin de décharger la cellule de batterie (10) au moins jusqu'à ce que la grandeur caractéristique (V) de l'état de charge atteigne la valeur limite supérieure.

15. Aide auditive (1), comprenant
- une cellule de batterie rechargeable (10)
- un module de mesure destiné à mesurer une valeur réelle (Vist) d'une grandeur caractéristique (V) d'un état de charge de la cellule de batterie (10),
- un module de comparaison destiné à comparer la valeur réelle mesurée (Vist) de la grandeur caractéristique (V) à une valeur limite supérieure (Vmax) de la grandeur caractéristique (V) de l'état de charge de la cellule de batterie (10) qui est spécifiée pendant un stockage à longue durée de l'aide auditive (1), et
- un module de décharge qui est conçu, dans le cadre d'une routine d'activation (24) d'un stockage à longue durée de l'aide auditive (1) dans le cas où la valeur réelle mesurée (Vist) de la grandeur caractéristique (V) de l'état de charge de la cellule de batterie (10) est située au-dessus de la valeur limite supérieure (Vmax), pour décharger la cellule de batterie (10) de l'aide auditive (1) au moins jusqu'à ce que la grandeur caractéristique (V) de l'état de charge ait atteint la valeur limite supérieure (Vmax),
l'aide auditive (1) étant conçue pour adopter un mode de stockage à longue durée (36) dans le cadre de la routine d'activation (24) du stockage à longue durée lorsque l'état de charge qui correspond à la valeur limite supérieure spécifiée (Vmax) de la grandeur caractéristique (V) est atteint,
**caractérisée en ce que**
l'aide auditive (1) est en outre conçue pour vérifier (42) de manière répétée son utilisation et pour lancer automatiquement la routine d'activation (24) du stockage à longue durée dès qu'aucune utilisation n'est effectuée pendant au moins une première durée (46).
